Europäisches Patentamt

European Patent Office

Office européen des brevets

(19)

(11) EP 0 948 138 B1

(12) **EUROPEAN PATENT SPECIFICATION**

(45) Date of publication and mention
of the grant of the patent:
**09.03.2005 Bulletin 2005/10**

(51) Int Cl.$^7$: **H03L 7/197**, H03K 23/66

(21) Application number: **98400805.2**

(22) Date of filing: **03.04.1998**

(54) **Frequency synthesiser**

Frequenzsynthetisierer

Synthétiseur de fréquence

(84) Designated Contracting States:
**DE FR GB**

(43) Date of publication of application:
**06.10.1999 Bulletin 1999/40**

(73) Proprietor: **MOTOROLA SEMICONDUCTEURS
S.A.**
**31023 Toulouse Cédex (FR)**

(72) Inventors:
• **Khlat, Nadim**
**31270 Cugneaux (FR)**
• **Trichet, Jacques**
**31270 Cugneaux (FR)**

(74) Representative: **Wharmby, Martin Angus**
**Freescale Semiconductor Inc.**
**c/o Impetus IP Limited**
**Grove House**
**Lutyens Close**
**Basingstoke, Hampshire RG24 8AG (GB)**

(56) References cited:
**EP-A- 0 019 412          WO-A-94/14243**

• **RILEY T A D ET AL: "DELTA-SIGMA
MODULATION IN FRACTIONAL-N FREQUENCY
SYNTHESIS" IEEE JOURNAL OF SOLID-STATE
CIRCUITS., vol. 28, no. 5, 1 May 1993, pages
553-559, XP000368743 NEW YORK US**

EP 0 948 138 B1

**Description**

FIELD OF THE INVENTION

The present invention relates to a frequency synthesiser and a method of generating carrier signals of different frequencies, and in particular to a frequency synthesiser and a method of generating carrier signals of different frequencies for use in transceiver apparatus of a radiotelephony system.

BACKGROUND OF THE INVENTION

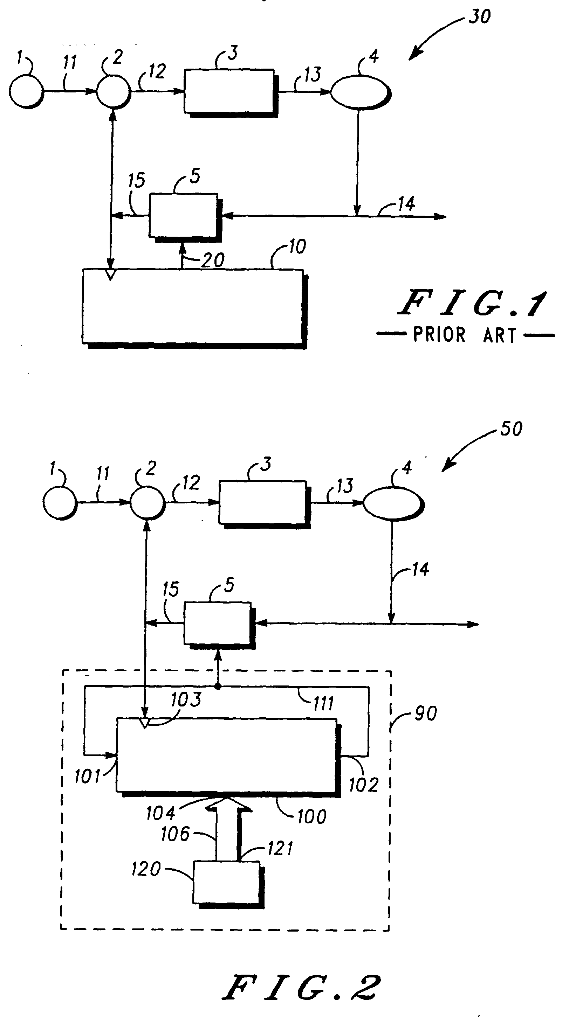

Figure 1 is a schematic block diagram of a known frequency synthesiser 30. It comprises in essence a reference frequency signal generator 1 which generates a substantially constant frequency reference signal 11 having a frequency Fref of, for example, a few Mhz, a Phase Lock Loop (PLL) arrangement 2, 3, 4, 5 and a sequence generator and applier 10. The PLL arrangement 2, 3 , 4 , 5 comprises a variable Voltage Controlled Oscillator (VCO) 4 which generates a variable frequency signal 14 which is generally of a much higher frequency than the reference signal 11. The variable frequency signal 14 is applied to a programmable frequency divider 5 which divides the input variable frequency signal by an integer amount and outputs a divided down signal 15. The integer amount by which variable frequency signal 14 is divided may be termed the divisor and it is generated by the sequence generator and applier 10 and applied to the divider 5 in the form of a digital divisor signal 20. The divided down signal 15 is then input to a phase detector 2. Reference signal 11 is also input to the phase detector 2. The phase detector 2 compares the phase of the two input signals 11, 15 and outputs a phase error signal 12 which is dependent upon the relative phase difference between the two input signals 11, 15. The phase error signal 12 is then passed through a low pass filter 3 to produce an averaged phase error signal 13 which is then applied to the VCO 4.

As is well known in the art, the net effect of the averaged phase error signal 13 as applied to the VCO 4 is to vary the frequency of variable frequency signal 14 output from the VCO so as to minimise the frequency difference between the two signals applied to the phase detector 2. In this way the frequency of variable frequency signal 14 output from the VCO 4 is locked to the frequency of the reference signal 11 multiplied by the divisor applied to divider 5 by divisor signal 20. The variable frequency signal 14 output from the VCO 4 forms the output of the frequency synthesiser 30 as a whole.

The sequence generator and applier 10 is a dedicated, sigma-delta type circuit which produces a relatively rapidly varying signal 20 in dependence on an input signal which corresponds to the frequency to be generated by the frequency synthesiser 30. Although the divider 5 is only able to divide by an integer value at any one instant, by varying the divisor sufficiently frequently compared to the corner frequency of the low pass filter 3, it is possible to lock the frequency of the variable frequency signal 14 output from the VCO 4 to the product of the frequency of the reference signal 14 and the average value of the divisor (time averaged over a period of time which is comparable to the inverse of the corner frequency of low pass filter 3).

The sequence generator and applier 10 operates on a sigma-delta type principle. To do this it includes at least one accumulator which accumulates the input number and outputs the carry out signal. The proportion of time that the carry out signal spends in a high state will then be equal to the ratio of the input number to the maximum number which the accumulator can store before the carry out signal goes high and the accumulator wraps back to zero. A frequency synthesiser employing a sequence generator and applier of this type is frequently referred to in the art as a fractional-N synthesiser because frequencies can be synthesised which are equal to a multiple of the reference signal frequency plus a fraction of the reference signal frequency. It is well known that such frequency synthesisers have a number of advantages over conventional PLL frequency synthesisers in terms of the noise output by the frequency synthesiser.

However, the use of a dedicated circuit to act as the sequence generator and applier has a number of drawbacks. Firstly silicon is required on which to form the circuit and power is consumed by the entire circuit during use which is constantly required in a conventional sequence generator. Further drawbacks with a conventional sequence generator and applier will become apparent during the following detailed description of the present invention.

From publication "Delta Sigma Modulation in Fractional-N Synthesis" by Riley et al.in IEEE Journal of Solid State Circuits, vol. 28, no. 5, 1 May 1993, pages 553-559, there is known a sequence generator and applier for applying a sequence to a frequency divider forming part of a frequency synthesiser, the sequence generator and applier including generating means for generating a sequence associated with one frequency to be synthesised by the frequency synthesiser, shift register storage means for storing the sequence once generated and application means for applying the sequence from the storage means to the frequency divider. However, in this known sequence generator and applier the shift register has a fixed single bit width.

SUMMARY OF THE INVENTION

The invention provides a sequence generator and applier as described in the accompanying claims.

The term generating a sequence is intended to cover nomorlly real-time calculation by a suitable circuit but also simply reaccessing the sequence from a memory where the sequence in question has been prestored.

A single suitably arranged circuit element may perform more than one function; for example, a suitably connected shift register could perform the functions of both the storage means and the application means, or an address pointer could perform the functions of both the generating means and the application means. Where the sequence is prestored, this may be done either in a non-volatile memory in which case the sequences may be generated externally in any convenient manner (e.g. by a computer) or the sequence may be stored in a suitable volatile memory forming part of the device in which the frequency synthesiser is to be incorporated, in which case the sequence may be generated by a processing unit forming part of the device either on power up of the device or on the first occasion that such a sequence is required.

Preferably, the sequence is cyclically applied to the frequency divider. In a preferred embodiment this is achieved using a shift register whose input is connected to its output during application of the sequence to the frequency divider. Ideally the shift register is of a variable length in terms of the number of words forming the sequence before completing a single cycle of the sequence. Furthermore, the shift register is also ideally of variable word length.

In an alternative embodiment, the frequency synthesiser is used to produce a frequency or phase modulated signal, in which case the sequence is not cyclically applied to the frequency divider. In this case each sequence represents not a particular fixed frequency but a finite part of a frequency or phase modulated signal. In this alternative embodiment, the sequence is preferably generated as it is required by a processing unit operating at rate which is greater than the rate at which the sequence is applied to the frequency divider. In this alternative embodiment, the storage means preferably comprises a First-In-First-Out (FIFO) (or other similar type of) buffer memory which permits the sequence to be read into the buffer at a greater rate (but for a shorter period of time) than it is read out.

BRIEF DESCRIPTION OF THE FIGURES

In order that the present invention may be better understood, embodiments thereof will now be described by way of example only with reference to the accompanying drawings in which:-

Figure 1 is a schematic block diagram of a frequency synthesiser incorporating a known sequence generator and applier;
Figure 2 is a schematic block diagram of a frequency synthesiser incorporating a sequence generator and applier according to a first embodiment of the present invention;
Figure 3 is a schematic block diagram of a sequence generator and applier according to a second embodiment of the present invention;
Figure 4 is a schematic block diagram of a shift register arrangement suitable for use with the present invention together with a frequency divider;
Figure 5 is similar to Figure 4 showing a slightly different arrangement of the shift register arrangement;
Figure 6 is similar to Figures 4 and 5 showing another slightly different arrangement of the shift register arrangement; and
Figure 7 is a schematic block diagram of a shift register suitable for use in a shift register arrangement suitable for use in the present invention.

DETAILED DESCRIPTION

Referring firstly to Figure 2, there is shown a schematic block diagram of a frequency synthesiser 50. With the exception of the sequence generator and applier 90 (in place of sequence generator and applier 10 of Figure 1) it is similar to the frequency synthesiser of Figure 1, and like reference numerals have been used to refer to corresponding elements. Thus, the frequency synthesiser of Figure 2 comprises in essence a reference frequency signal generator 1 which generates a substantially constant frequency reference signal 11 having a frequency Fref of, for example, a few Mhz, a Phase Lock Loop (PLL) arrangement 2, 3, 4, 5 and a sequence generator and applier 90. The PLL arrangement 2, 3 , 4 , 5 comprises a variable Voltage Controlled Oscillator (VCO) 4 which generates a variable frequency signal 14 which is generally of a much higher frequency than the reference signal 11. The variable frequency signal 14 is applied to a programmable frequency divider 5 which divides the input variable frequency signal by an integer amount and outputs a divided down signal 15. The integer amount by which variable frequency signal 14 is divided may be termed the divisor and it is generated by the sequence generator and applier 90 and applied to the divider 5 in the form of a digital divisor signal. Note that the output signal 111 from shift register arrangement 100 described below forms only a part of the digital divisor signal 20 of Figure 1. The divided down signal 15 is then input to a phase detector 2. Reference signal 11 is also input to the phase detector 2. The phase detector 2 compares the phase of the two input signals 11, 15 and outputs a phase error signal 12 which is dependent upon the relative phase difference between the two input signals 11, 15. The phase error signal 12 is then passed through a low pass filter 3 to produce an averaged phase error signal 13 which is then applied to the VCO 4.

As is well known in the art, the net effect of the averaged phase error signal 13 as applied to the VCO 4 is to vary the frequency of variable frequency signal 14 output from the VCO so as to minimise the frequency difference between the two signals applied to the phase detector 2. In this way the frequency of variable frequency signal 14 output from the VCO 4 is locked to the frequency of the reference signal 11 multiplied by the divisor applied to divider 5 by the divisor signal. The variable frequency signal 14 output from the VCO 4 forms the output of the frequency synthesiser 50 as a whole.

The sequence generator and applier 90 comprises a shift register arrangement 100, which acts as a storage means and an application means, and generating means 120. The shift register arrangement 100 has an input 101, an output 102, a clock terminal 103 and a parallel-input 104. The output 102 is connected both to the frequency divider 5 and to the input 101 of the shift register arrangement 100. The shift register arrangement 100 is clocked via its clock terminal 103 by the divided down signal 15 output from divider 5. The generating means 120 has a parallel-output 121 which is connected to the parallel-input 104 of the shift register arrangement 100.

In operation, the generating means 120 generates a sequence under the control of a suitable controlling processing unit (not shown) such as a microcontroller unit or a Digital Signal Processor (DSP). The sequence thus generated is then loaded into shift register arrangement 100 via a parallel digital signal 106. Once the sequence is loaded into the shift register 100, the sequence is cyclically applied to the frequency divider 5. The shift register is clocked by the divided down signal 15 so as to ensure good synchronisation between the change of the divisor value and the output signal 14 which is important to minimise the noise content of output signal 14. The sequence continues to be cyclically applied to the frequency divider 5 until a new sequence is required whereupon the above described process is repeated under the control of the controlling processing unit.

The generating means 120 in this example is a hardware implementation similar to the sequence generator and applier 10 of Figure 1. However, there are two important distinctions between generating means 120 and sequence generator and applier 10. Firstly, the former does not need to be clocked by the divided down signal because of the buffering effect provided by shift register arrangement 100 which is clocked by the divided down signal. Secondly, where the frequency synthesiser 50 is being used to synthesise a substantially constant frequency, the latter needs to be constantly processing whereas the former only needs to process a single sequence and can then lie dormant until the frequency synthesiser is required to generate a new frequency.

The first distinction enables the generating means 120 to be clocked more slowly than the sequence generator and applier 10 in which case either power consumption savings during operation or cost savings at manufacture or both may be made as a result of the lower processing speed required. Alternatively, the generating means 120 may be clocked more quickly than the sequence generator and applier 10. This is advantageous where the generating means 120 is actually just a non-dedicated DSP, since then the sequence can be generated in a very short space of time (relative to the amount of time taken to apply the sequence to the frequency divider 5 - i.e. having a low duty cycle). In this way a non-dedicated DSP which is already present in the device for other functions but which has a little overcapacity in terms of MIPS (Millions of Instructions Per Second) can be utilised thus removing the need for a separate specific circuit for the generating means 120.

The second distinction results in power savings where the frequency synthesiser 50 synthesises the same frequency for significantly long periods of time relative to the time taken to apply a single sequence to the frequency divider 5, as is the case in many applications, since the shift register arrangement 100 will generally consume much less power than the conventional sequence generator and applier 10.

Furthermore, the second distinction is also the basis for the solution by the present invention of a problem associated with the conventional sequence generator and applier 10. The problem concerns the generation of noise spurs at frequencies which are subharmonics of the reference frequency Fref. These subharmonic spurs can arise in the conventional arrangement at inconveniently low frequencies as a result of the sequence generator and applier 10 generating sequences which are not as short as they could be.

For example, in a simple 1-bit wide sequence which seeks to synthesise a signal whose frequency is an arbitrary integer multiple of Fref plus a quarter of Fref, sequence generator and applier 10 might generate the sequence 00100100/00100100/00100100 it can be seen that this sequence repeats every 8 bits although in fact only the first 4 bits are required to generate the desired fraction. According to the present invention, it would be possible to load only the first 4 bits of the sequence into the shift register giving rise to the sequence 0010/0010/0010 which repeats every 4 bits. Since the shift register arrangement is clocked by the divided down signal 15, whose frequency on average is approximately equal to Fref, it is apparent that a periodicity of 8 bits can give rise to a subharmonic spur at Fref/8. Where adjacent channels are separated by a frequency of Fref/4, this would then create a spur in the middle of the channel whereas the sequence having a period of 4 bits would only create a spur at Fref/4 which would be at the edge of the channel and can thus be filtered out.

Where a non-dedicated DSP is used as the generating means 120, it is possible to use sophisticated sequence generating algorithms which shape the quantisation noise associated with the switching between different frequencies. This might include digital integration of the noise as is commonly done in conventional sequence generator and appliers to ensure that there is zero noise at dc; however, it could advantageously include more complicated noise shaping to ensure that further zeros are formed at non-dc frequencies (see co-pending European patent application No. 98400498.6 the contents of which with regard to noise shaping are hereby incorporated herein). Additionally, where the generating means 120 is used for direct modulation, it may be further advantageous to shape the modulating signal to account for any distortion of the signal created by the PLL process of the frequency synthesiser.

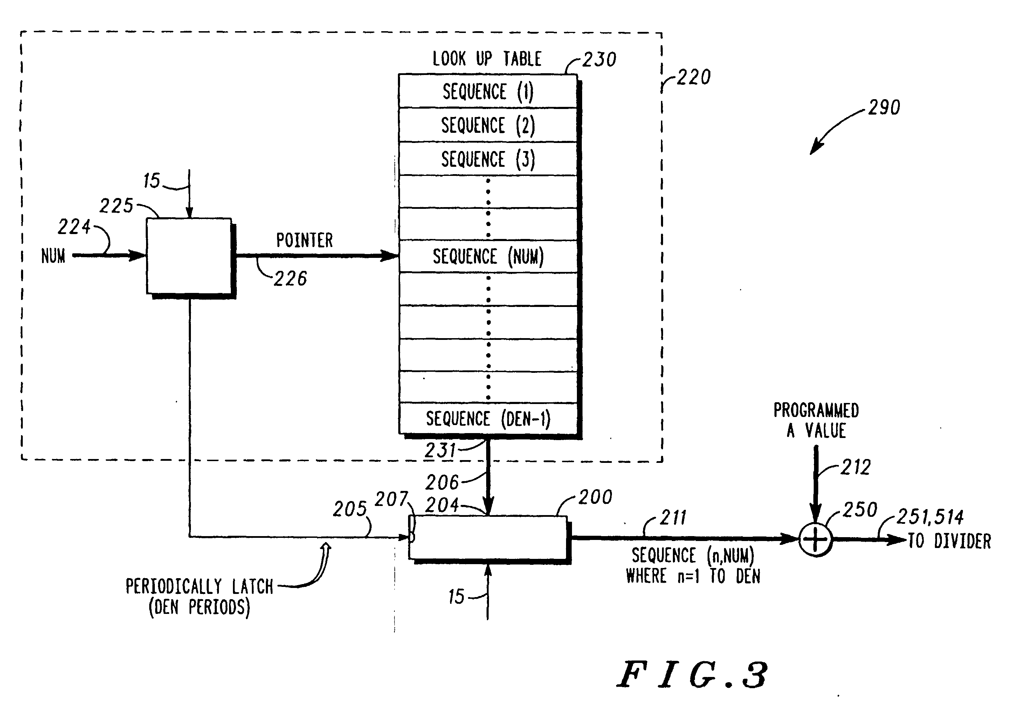

Figure 3 shows a second embodiment of a sequence generator and applier 290 according to the present invention. Its principal components are again a shift register arrangement 200 and generating means 220 although there is additionally shown an adder 250 whose function is described in greater detail below. The shift register arrangement in this case takes the form of a plurality of one bit wide shift registers operating in parallel such that the output from the shift register arrangement is a multibit digital signal 211 which is applied to adder 250. The shift register arrangement 200 is clocked by divided down signal 15 as before. The shift register arrangement 200 also includes a parallel-input 204 and a latch input 207 which together operate such that when a latch signal applied to the latch input 207 takes on a suitable value (i.e. a "latch" value as opposed to a "not latched" value) the data applied to the parallel input 204 is read into the shift register arrangement 200.

The generating means 220 principally comprises a section of memory configured as a look up table 230 and a simple processing segment which acts as a pointer controller 225 to provide an address pointer 226 to the look up table 230. The look up table 230 contains as many storage locations as there are sequences which may be required to be "generated" with each storage location storing a required sequence. The look up table 230 has an output 231 from which is output a look up table output signal 206 which simply corresponds to whichever of the storage locations is being pointed to by the address pointer 226.

For reasons which will be explained in greater detail below, the number of required sequences (and thus storage locations needed in the look up table 230) will generally be considerably less than the number of different frequencies which the frequency synthesiser is able to synthesise such that only a relatively modest amount of memory is required for this purpose. However, each sequence will comprise a number of words each of which may be more than one bit wide. Generally speaking, if each sequence is DEN words long and each word is C bits wide (where DEN and C are variables which will be described in greater detail below) then for a constant-frequency synthesiser (as opposed to a modulated-frequency synthesiser), DEN - 1 storage locations will be required in the look up table 230 each location being able to store DEN x C bits. This may conveniently be achieved by utilising C similar memories each able to store DEN bits, the memories operating in parallel with each memory being associated with its own 1 bit wide shift register.

During operation of the sequence generator and applier 290 of Figure 3, a controlling processing unit generates values for variables N, A and NUM (whose meanings will be described in greater detail below) and applies NUM to the pointer controller 225 by means of a digital NUM signal 224. Pointer controller 225 is clocked by divided down signal 15 and generates address pointer signal 226 in dependence on the input NUM signal every DEN clock cycles (note the address pointer is continuously applied but may only change every DEN clock cycles). It also generates a latch signal 205 which is applied to the latch input 207 of the shift register arrangement 200.

Generally, latch signal 205 has a "not latched" value but it takes on a "latch" value for a single clock cycle after every DEN clock cycles (this being the same clock cycle when a new address pointer signal 226 may be generated - if NUM has changed since the last opportunity). When the latch signal has a "latch" value, shift register arrangement is loaded with the contents of whichever storage location in the look up table 230 is being pointed to by address pointer 226. Thereafter, the sequence loaded into shift register 200 is serially applied to adder 250 by means of signal 211. After DEN clock cycles the sequence ends and a new sequence is loaded into the shift register arrangement 200. Where the same frequency is to be synthesised by the frequency synthesiser, NUM signal will remain constant and thus the same sequence will be reloaded into the shift register arrangement 200 and thus the same sequence will effectively be cyclically output from the shift register arrangement 200 as before until a new NUM value is applied to pointer controller 225.

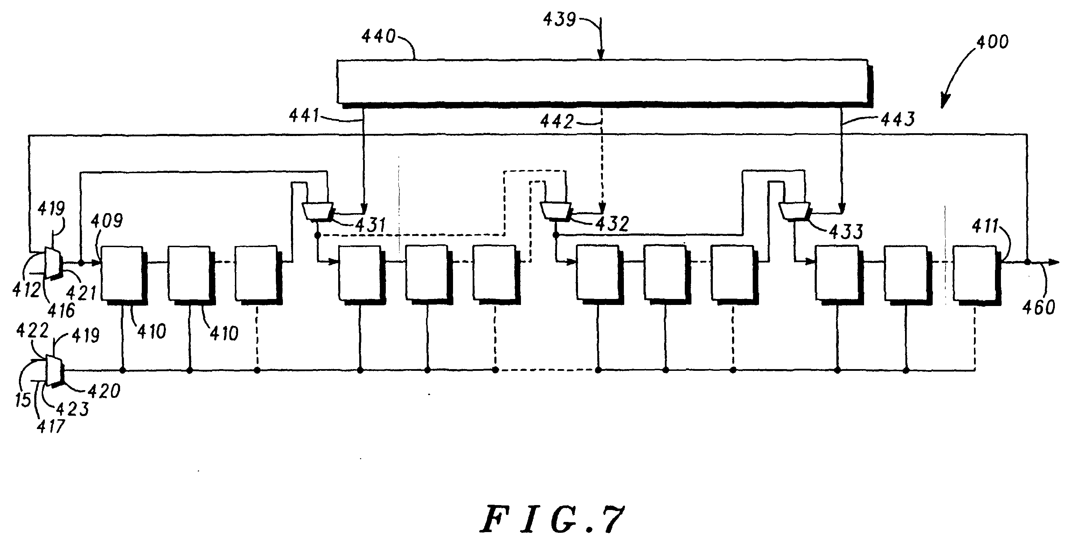

Of course, the shift register arrangement 200 could be made to be cyclical itself (see Figure 7 and the accompanying description below). With such an arrangement it would not be necessary to power up simple processing segment 225 and look up table 230 until a new sequence is to be fed into shift register arrangement 200.

The variable A is also applied to adder 250 by means of digital A signal 212. Adder 250 generates an adder output signal 251, 514 which is described in greater detail below.

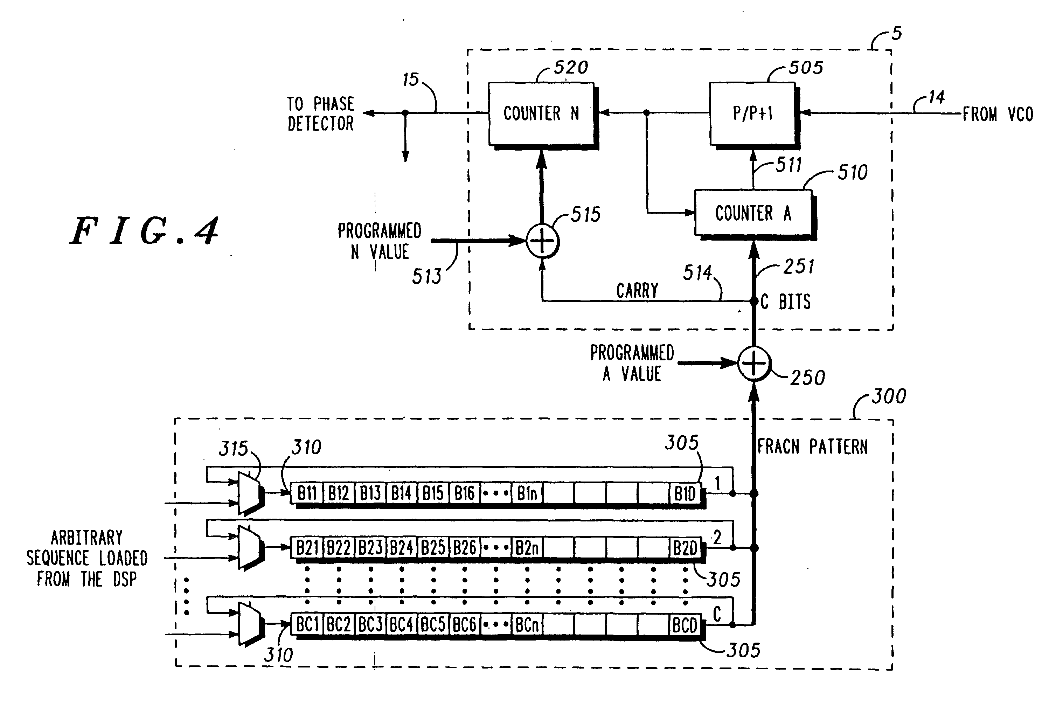

Turning now to Figure 4, there is shown a shift register arrangement 300 together with frequency divider 5 shown in greater detail. Shift register arrangement 300 comprises C 1-bit wide shift registers 305 operating together in parallel. Each shift register 305 has only a single serial input 310 (no parallel input) which receives a signal output from a multiplexer 315, each shift register 305 having an associated multiplexer 315 connected to its input 310. Each multiplexer 315 receives as inputs the output from its associated shift register 305 and the output from a generating means for generating a suitable sequence (not shown). The output of each multiplexer will be one or other of the two inputs in dependence on a control signal applied to a control input of each multiplexer 315, the control signal being generated by a suitable controlling processing unit (not shown).

When a new sequence is to be loaded into shift register arrangement 300 each multiplexer 315 is controlled to output the signal from the generating means; otherwise, each multiplexer is controlled to output the output from its respective shift register 305 such that the sequence contained within the shift register arrangement cycles continuously until a new sequence is loaded. The individual outputs of each of the shift registers 305 are combined to form a multibit shift register arrangement output signal 311. The sequence contained within the shift register arrangement 300 may be described mathematically as S(i) where i ranges from 1 to DEN and where ΣS(i)=NUM and the average value of S(i) is equal to NUM/DEN. Signal 311 is applied to adder 250 where it is added to digital A signal 212 to produce adder output signal 251, 514 which is mathematically equal to A' where A' = A + S(i).

The frequency divider 5 comprises a P counter 505, an A counter 510, an N adder 515 and an N counter 520. The frequency divider 5 receives output signal 14 from VCO 4 as a first input, adder output signal 251, 514 as a second input and a digital N signal 513 as a third input signal; together, signals 251, 514 and 513 constitute the digital divisor signal. Frequency divider 5 generates divided down signal 15 as an output which is applied to shift register arrangement 300 as the clock signal therefor as well as to phase detector 2. P counter 505 is capable of counting either to P or to P+1 under the control of an output signal 511 from A counter 510, where P is a predetermined integer which may for example be 10. The adder output signal 251, 514 is separated into two separate signals: an A'rem signal 251 and an A'carry signal 514, where A'carry is the quotient of (A'/P) and A'rem is the remainder of (A'/P) which is also equal to A' - A'carry. A'rem signal 251 is input to A counter 510 and causes it to count up to A'rem. The A'carry signal 514 is input to N adder 515 together with N signal 513 and causes N adder 515 to output an N' signal 516, where N' = N + A'carry. N' signal 516 is input to N counter 520 and causes N counter to count up to N'.

The effect of frequency divider 5, expressed mathematically, is to divide output signal 14 by an amount NL whose average value is given by:

$$\text{Average NL} = N{\cdot}P + A + NUM/DEN$$

In order to achieve this effect, the frequency divider 5 operates as follows. At the beginning of each cycle of the frequency divider 5 all counters 505, 510, 520 are reset to zero. Initially, P counter 505 counts up to P+1 (e.g. 11) and then issues an output pulse which increments both A counter 510 and N counter 520 while it reverts back to a count of zero itself. As soon as P counter has issued A'rem output pulses (and thus A counter 510 has counted A'rem such pulses) the output signal 511 from A counter changes and P counter starts counting only up to P (e.g. 10) before issuing an output pulse and reverting its count back to zero. After this the P counter continues to count only up to P regardless of how many further pulses are output by the P counter 505. Meanwhile, N counter 520 continues to increment its count for every output pulse issued by P counter 505 until N' pulses have been counted whereupon an output pulse is emitted by N counter 520 (note this assumes that N' is greater than A'rem). The output from N counter 520 forms the divided down signal 15 output from the frequency divider 5 as a whole, and the upward transition associated with each pulse is used by the phase comparator 2 to compare the phase of the divided down signal 15 with the reference signal 11. Additionally, each upward transition output by N counter 520 is used to reset the A and P counters 510,505 (or at least the A counter 510) so as to restore the frequency divider 5 as a whole back to the situation at the beginning of the cycle whereupon the cycle repeats.

It will be apparent from the above description that the total number of upward (or downward) transitions NL counted by the P counter 505 before issuance of a pulse by the N counter 520 (and therefore the value of the divisor by which the signal 14 from the VCO is divided) will be given by:

$$NL = A'rem{\cdot}(P+1) + (N'-A'rem){\cdot}P$$

$$= N'{\cdot}P + A'rem = N{\cdot}P + A'carry{\cdot}P + A'rem$$

$$= N{\cdot}P + A' = N{\cdot}P + A + S(i)$$

$$\Rightarrow \text{Average NL} = N{\cdot}P + A + NUM/DEN \text{ -as required}$$

In the shift register arrangement 300 of Figure 4, each shift register 305 has a fixed length of bits. In this way the length of each sequence which can be stored in the shift register arrangement 300 is also almost completely fixed (it would, of course, be possible to store the same sequence twice, three times, etc. where the sequence was half, a third, etc. as long as the number of bits in each shift register 305 but this does not give very much flexibility to the length of each sequence). The integer DEN is equal to the length of the sequence stored in shift register arrangement 300. Therefore, to all intents and purposes DEN is a fixed integer value for a given length of the shift registers 305.

In order for a frequency synthesiser employing the shift register arrangement 300 and frequency divider 5 of Figure 4 to generate a fixed frequency output signal 14, a controlling DSP will generate the appropriate values of N, A and NUM, DEN and P being fixed integers. For example, supposing the frequency synthesiser is to generate an output signal 14 having a frequency equal to 104.2Fref where P and DEN are both equal to 10. Since NL = NP + A + NUM/DEN , suitable values of N, A and NUM will be 10, 4 and 2 respectively. Once these numbers have been generated by the controlling DSP, the generating means will generate a suitable sequence on the basis of NUM (and possibly also DEN) which is then loaded into the shift register arrangement 300. Thereafter, the frequency synthesiser operates as described above to synthesise an output signal 14 having a frequency of 104.2Fref as desired.

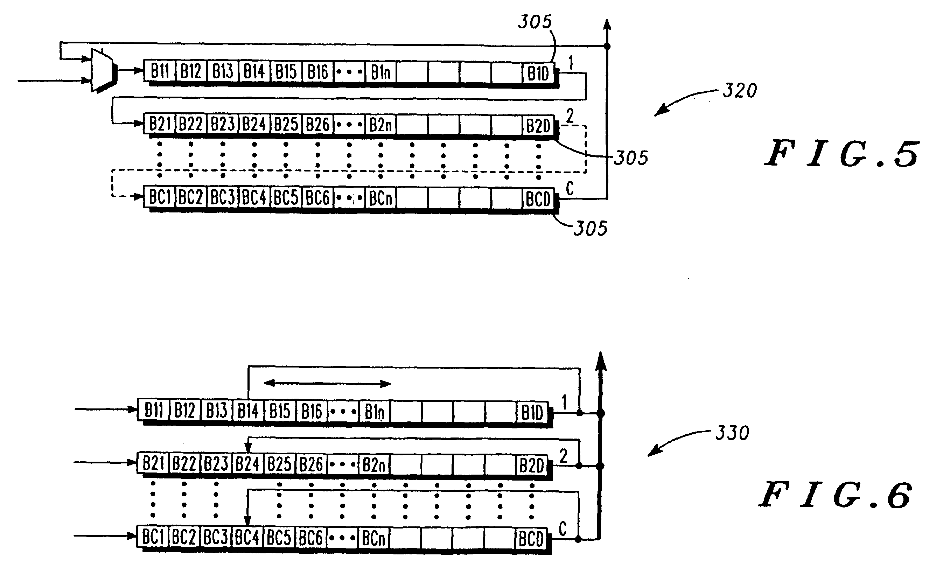

Figure 5 shows a shift register arrangement 320 which is similar to the arrangement 300 shown in Figure 4 except that the shift registers 305 have been connected together in series rather than in parallel to form a single 1-bit wide shift register which is C times longer than the arrangement 300 (where C is the number of 1-bit wide shift registers 305 in both cases). It is apparent that mixed arrangements may occur where appropriate (e.g. forming a 2-bit wide arrangement which is C/2 times longer than in the arrangement 300 - this of course requires C to be an even number).

Figure 6 shows a further shift register arrangement 330 which is again similar to the arrangement of Figure 4 except that in this case the output of each shift register 305 may be connected to any desired part of the shift register 305 instead of just its input. In this way the length of sequence which may be cyclically applied to the frequency divider 5 may be varied. Clearly the sequence initially loaded into the shift register arrangement 330 will have to have as many words as each register 305 has bits, but some of the bits last loaded will not be used and are irrelevant, stuffing bits.

Figure 7 shows a low-level example of a 1-bit wide shift register circuit 400 which could be used to build a shift register arrangement similar to that shown in Figure 6. It comprises a plurality of 1-bit delay units 410 which could for example be simple D-flip-flops, a clock multiplexer 420, a data multiplexer 421, skip multiplexers 431, 432, 433 and a skip logic unit 440. The delay units 410 can be thought of as together forming a 1-bit wide shift register having an input 409 and an output 411.

The output 411 is connected to a first input 412 of data multiplexer 421 whose output is connected to the shift register input 409. Additionally, data multiplexer 421 has a second input 416 which can receive a new sequence to be loaded into the shift register from a sequence generating means (either directly or via a DSP or storage medium, etc.). Clock multiplexer 420 has a first input 422 which receives the divided down signal 15 and a second input 423 which can receive a load-clock signal 417 from, for example, a controlling DSP. The output from the clock multiplexer 420 is applied to clock inputs of each delay unit 410 and is used to clock the shift register.

Both the data multiplexer 421 and the clock multiplexer 420 are controlled by a load/cycle signal 419 which may adopt either a load value or a cycle value. When the load/cycle signal 419 adopts a load value, the outputs of the data and clock multiplexers are connected to their second inputs 416, 423. Conversely, when the load/cycle signal 419 adopts a cycle value, the outputs of the data and clock multiplexers are connected to their first inputs 412, 422. In this way, a new sequence can be loaded into the shift register at a rate determined by the load clock signal by causing load/cycle signal 419 to adopt a load value and applying the sequence to be loaded to the second input of the data multiplexer. Once the new sequence has been loaded, the load/cycle signal 419 is caused to adopt a cycle value and thereafter the shift register will be clocked by the divided down signal and the sequence will be recycled from the output 411 of the shift register to its input 409 via the data multiplexer 421.

By using a different load clock frequency to the cycle clock frequency, it is possible to load the new sequence very quickly compared to the divided down signal period, which may be advantageous where it is desired to change the synthesised frequency with the minimum of interruption. Alternatively, the load clock frequency could be much slower than the divided down signal frequency where it is desired to load the sequence directly from a hardware circuit generating means which is run at a relatively slow rate for reasons of economy.

In order to enable the length of sequence which is to be cyclically applied to be varied under the control of a controlling DSP, a number of skip multiplexers 431, 432, 433 are provided at intervals between the delay units 410, each multiplexer receiving as inputs the output from the skip multiplexer immediately preceding it ( or, in the case of the first skip multiplexer 431, the input 409 to the shift register) and the output of the delay unit immediately preceding it. The output of each skip multiplexer is connected to the input of the immediately following delay unit. The skip multiplexers are individually controlled by control signals 441, 442, 443 generated by the skip logic unit 440 which in turn is controlled by a DEN length signal 439 which reflects the length of sequence to be stored in the shift register. Each control signal 441, 442, 443 may adopt either a normal or a skip value. When every control signal adopts a normal value, the shift register will cycle a sequence as long as the entire shift register. However, when any of the control signals adopts a skip value, the respective skip multiplexer will output the input received from the preceding multiplexer rather than the immediately preceding delay unit and as a result the delay units located between the respective multiplexer and the immediately preceding multiplexer will be skipped thus effectively reducing the length of the shift register by the number of delay units so skipped. In this way the value of DEN may be varied. Clearly, although Figure 7 shows the skip multiplexers located at intervals of every 3 delay units, this interval could be reduced to one delay unit or varied numbers of delay units (e.g. 1, 2, 4, 8, etc.) to provide better control of the variation of DEN.

## Claims

1. A sequence generator and applier for applying a sequence to a frequency divider (5) forming part of a frequency synthesiser (50), the sequence generator and applier (90) including generating means (120) for generating a sequence associated with one or more frequencies to be synthesised by the frequency synthesiser (50), storage means (100) for storing the sequence once generated and application means for applying the sequence from the storage means (100) to the frequency divider (5), **characterised in that** the generating means is coupled to the storage means such that the sequence is transferred from the generating means to the storage means in at least one parallel word having a length of at least two bits, the storage means (100) comprises a shift register arrangement, the output (102) of the shift register arrangement is connectable to the input (101) of the shift register arrangement whereby the sequence stored within the shift register arrangement (100) may be cyclically applied to the frequency divider (5), and the shift register arrangement (100) has a variable length.

2. A sequence generator and applier as claimed in claim 1 wherein the generating means (120) comprises a look up table in which the sequence to be generated is stored.

3. A sequence generator and applier as claimed in claim 2 wherein the look up table is formed in non-volatile memory.

4. A sequence generator and applier as claimed in claim 2 wherein the look up table is formed in volatile memory.

5. A sequence generator and applier as claimed in claim 1 wherein the generating means comprises a dedicated circuit.

6. A sequence generator and applier as claimed in claim 1 wherein the generating means (120) comprises a digital signal processor operating at a clock frequency which is much greater than the rate at which the application means applies the sequence to the frequency divider (5).

7. A sequence generator and applier as claimed in any preceding claim wherein the shift register arrangement (100) has a variable bit width.

## Patentansprüche

1. Sequenzgenerator und -anwender zum Anwenden einer Sequenz auf einen Frequenzteiler (5), der einen Teil eines Frequenzsynthesizers (50) bildet, wobei der Sequenzgenerator und -anwender (90) Erzeugungsmittel (120) zum Erzeugen einer Sequenz, die mit einer oder mehreren durch den Frequenzsynthesizer (50) zu synthetisierenden Frequenzen in Beziehung steht, Speichermittel (100) zum Speichern der einmal erzeugten Sequenz und Anwendungsmittel zum Anwenden der Sequenz aus den Speichermitteln (100) auf den Frequenzteiler (5) umfasst,

   **dadurch gekennzeichnet, dass** die Erzeugungsmittel derart an die Speichermittel gekoppelt sind, dass die Sequenz von den Erzeugungsmitteln in mindestens einem Parallelwort mit einer Länge von mindestens zwei Bits zu den Speichermitteln übertragen wird, wobei die Speichermittel (100) eine Schieberegisteranordnung umfassen, wobei der Ausgang (102) der Schieberegisteranordnung mit dem Eingang (101) der Schieberegisteranordnung verbindbar ist, wodurch die in der Schieberegisteranordnung (100) gespeicherte Sequenz zyklisch auf den Frequenzteiler (5) angewendet werden kann und die Schieberegisteranordnung (100) eine variable Länge aufweist.

2. Sequenzgenerator und -anwender nach Anspruch 1, wobei die Erzeugungsmittel (120) eine Nachschlagetabelle umfassen, in der die zu erzeugende Sequenz gespeichert ist.

3. Sequenzgenerator und -anwender nach Anspruch 2, wobei die Nachschlagetabelle in einem nicht-flüchtigen Speicher gebildet ist.

4. Sequenzgenerator und -anwender nach Anspruch 2, wobei die Nachschlagetabelle in einem flüchtigen Speicher gebildet ist.

5. Sequenzgenerator und -anwender nach Anspruch 1, wobei die Erzeugungsmittel eine zugeordnete Schaltung umfassen.

6. Sequenzgenerator und -anwender nach Anspruch 1, wobei die Erzeugungsmittel (120) einen digitalen Signalprozessor umfassen, der bei einer Taktfrequenz arbeitet, die weitaus größer ist als die Rate, mit der die Anwendungsmittel die Sequenz auf den Frequenzteiler (5) anwenden.

7. Sequenzgenerator und -anwender nach einem der vorhergehenden Ansprüche, wobei die Schieberegisteranordnung (100) eine variable Bitbreite aufweist.

## Revendications

1. Générateur et applicateur de séquence, servant à appliquer une séquence à un circuit diviseur de fréquence (5) faisant partie d'un synthétiseur de fréquence (50), le générateur et applicateur de séquence (90) comprenant des moyens de génération (120) pour générer une séquence associée à une ou plusieurs fréquences devant être synthétisées par le synthétiseur de fréquence (50), des moyens de stockage (100) pour stocker la séquence une fois qu'elle a été générée, et des moyens d'application pour appliquer la séquence des moyens de stockage (100) au circuit diviseur de fréquence (5),

**caractérisé en ce que** les moyens de génération sont couplés aux moyens de stockage de telle sorte que la séquence soit transférée des moyens de génération aux moyens de stockage dans au moins un mot parallèle ayant une longueur d'au moins deux bits ; les moyens de stockage (100) comprennent un agencement formant registre à décalage, la sortie (102) de l'agencement formant registre à décalage peut être reliée à l'entrée (101) de l'agencement formant registre à décalage de telle sorte que la séquence stockée dans l'agencement formant registre à décalage (100) puisse être appliquée de manière cyclique au circuit diviseur de fréquence (5) ; et l'agencement formant registre à décalage (100) a une longueur variable.

2. Générateur et applicateur de séquence selon la revendication 1, dans lequel les moyens de génération (120) comprennent une table de correspondance dans laquelle est stockée la séquence à générer.

3. Générateur et applicateur de séquence selon la revendication 2, dans lequel la table de correspondance est formée dans une mémoire non volatile.

4. Générateur et applicateur de séquence selon la revendication 2, dans lequel la table de correspondance est formée dans une mémoire volatile.

5. Générateur et applicateur de séquence selon la revendication 1, dans lequel les moyens de génération comprennent un circuit dédié.

6. Générateur et applicateur de séquence selon la revendication 1, dans lequel les moyens de génération (120) comprennent un processeur de traitement numérique du signal fonctionnant à une fréquence d'horloge qui est beaucoup plus grande que la cadence à laquelle les moyens d'application appliquent la séquence au circuit diviseur de fréquence (5).

7. Générateur et applicateur de séquence selon l'une quelconque des revendications précédentes, dans lequel l'agencement formant registre à décalage (100) a une largeur de bits variable.

*FIG.1*

— PRIOR ART —

*FIG.2*

LOOK UP TABLE ⌐230

SEQUENCE (1)
SEQUENCE (2)
SEQUENCE (3)
⋮
SEQUENCE (NUM)
⋮
⋮
SEQUENCE (DEN-1)

POINTER

NUM

PERIODICALLY LATCH
(DEN PERIODS)

PROGRAMMED
A VALUE

SEQUENCE (n,NUM)
WHERE n=1 TO DEN

251,514
TO DIVIDER

FIG.3

FIG.4

EP 0 948 138 B1

EP 0 948 138 B1

305

| B11 | B12 | B13 | B14 | B15 | B16 | · · · | B1n | | | | | B1D | 1

320

| B21 | B22 | B23 | B24 | B25 | B26 | · · · | B2n | | | | | B2D | 2

305

| BC1 | BC2 | BC3 | BC4 | BC5 | BC6 | · ·· | BCn | | | | | BCD | C

305

*FIG.5*

| B11 | B12 | B13 | B14 | B15 | B16 | · · · | B1n | | | | | B1D | 1

| B21 | B22 | B23 | B24 | B25 | B26 | · · · | B2n | | | | | B2D | 2

330

| BC1 | BC2 | BC3 | BC4 | BC5 | BC6 | · · · | BCn | | | | | BCD | C

*FIG.6*

*FIG.7*

EP 0 948 138 B1